# FASCICULE DE BREVET EUROPEEN

(11) **EP 1 191 125 B1**
(45) Date de publication et mention de la délivrance du brevet: **28.07.2010**
(21) Numéro de dépôt: 01402411.1
(22) Date de dépôt: 20.09.2001
(51) Int. Cl.: C23C 28/00, C23C 14/34, C23C 14/16

(54) **Procédé de réalisation d'un revêtement de barrière thermique**
Verfahren zum Herstellen einer Wärmedämmschicht
Method for making a thermal barrier coating

(30) Priorité: 25.09.2000 FR 0012145
(43) Date de publication de la demande: 27.03.2002
(73) Titulaire: SNECMA, 75015 Paris (FR)
(72) Inventeur: Saint Ramond, Bertrand, 77330 Fontainebleau (FR); Nicholls, John, Great Horwood MK7 0RH, Buckinghamshire (GB)
(74) Mandataire: Joly, Jean-Jacques

(56) Documents cités:
- EP-A- 0 985 744
- US-A- 5 292 594
- US-A- 5 490 911
- US-A- 5 856 027
- DATABASE COMPENDEX [en ligne] ENGINEERING INFORMATION, INC., NEW YORK, NY, US; NICHOLLS J R ET AL: "Platinum aluminide diffusion barrier for the oxidation protection of titanium and titanium intermetallic alloys" Database accession no. EIX96433304466 XP002170022 & PROCEEDINGS OF THE 1996 125TH TMS ANNUAL MEETING;ANAHEIM, CA, USA FEB 4-8 1996, 1996, pages 199-208, Warrendale, PA, USA

## Description

L'invention concerne la réalisation de pièces comprenant un substrat métallique muni d'un revêtement de protection formant barrière thermique.

Le domaine d'application de l'invention est la réalisation de pièces capables de conserver leurs propriétés mécaniques aux températures élevées, en particulier de pièces de turbine à gaz, telles que des aubes de turbine, notamment pour des turboréacteurs.

Pour améliorer les performances, en particulier le rendement, des turbines à gaz, il est souhaitable de les faire fonctionner aux températures les plus élevées possibles. Pour la réalisation de pièces des parties chaudes, il est bien connu à cet effet d'utiliser des superalliages. Habituellement, ceux-ci comprennent du nickel, comme constituant principal, et des éléments additionnels généralement choisis parmi le chrome, le cobalt, l'aluminium, le molybdène, le titane, le tantale et bien d'autres.

Un accroissement supplémentaire de la température de fonctionnement est rendu possible en munissant le substrat métallique des pièces d'un revêtement de protection formant une barrière thermique.

Il est connu à cet effet de réaliser un revêtement de protection multicouches comprenant une couche externe en céramique et une sous-couche de liaison métallique, en particulier une sous-couche comprenant de l'aluminium et un autre métal tel que du platine.

La sous-couche de liaison interposée entre le substrat métallique en superalliage et la couche externe céramique a pour fonctions :
- de permettre la formation et la persistance à sa surface d'un film d'alumine ayant des propriétés "adhésives" pour favoriser l'accrochage de la couche céramique externe,
- de protéger le substrat de la corrosion par oxydation par de l'oxygène du milieu ambiant ayant pu traverser la couche céramique externe, et
- de constituer une barrière de diffusion vis-à-vis d'éléments du substrat métallique qui seraient susceptibles de contaminer le film d'alumine et, par voie de conséquence, d'affecter l'interface entre la sous-couche de liaison et la couche céramique externe, donc d'affecter l'adhérence de cette dernière.

L'introduction au sein de la sous-couche de liaison, d'éléments réactifs tels que l'yttrium, le cérium, l'hafnium ou les lanthanides, renforce la fonction de barrière de diffusion et favorise la persistance du film "adhésif' d'alumine.

Il est bien connu de former une sous-couche de liaison de type MCrAIY (M étant un métal tel que Fe, Ni, Co) par un procédé de dépôt physique en phase vapeur, par exemple par projection plasma, sans induire de réaction avec le substrat, l'adhésion de la sous-couche de liaison sur le substrat étant de nature mécanique. On pourra se référer par exemple aux documents US 4 055 705 et US 5 824 423. Toutefois, afin d'obtenir une sous-couche stable thermiquement, il est nécessaire de lui conférer une épaisseur relativement importante, typiquement au moins 50 à 100 µm, ce qui est pénalisant en terme de masse.

D'autres procédés connus consistent à réaliser une sous-couche de liaison en un composé intermétallique qui, du fait de sa stabilité thermique, peut avoir une épaisseur plus faible. Un composé intermétallique comprenant de l'aluminium et du platine a démontré de bonnes propriétés.

Ainsi, le brevet US 5 716 720 décrit un procédé consistant à former une couche de platine par voie électrolytique sur un substrat en superalliage à base de nickel et à réaliser ensuite une aluminisation en phase vapeur à une température supérieure à 1 000°C. Du nickel provenant du substrat diffuse au sein de la sous-couche de liaison. Un film d'alumine est formé par traitement thermique à la surface de la sous-couche de liaison avant formation d'une couche externe céramique par exemple en zircone yttriée obtenue par dépôt physique en phase vapeur. Un élément réactif peut être introduit dans la sous-couche de liaison lors de l'étape d'aluminisation en phase vapeur.

Le brevet US 5 238 752 décrit un autre procédé consistant à former sur un substrat en superalliage une sous-couche de liaison en un composé intermétallique, notamment un composé d'aluminium et de platine. La sous-couche de liaison est réalisée par cémentation en pack à une température supérieure à 985°C et a une épaisseur supérieure à 25 µm. Un film d'alumine est formé par oxydation à la surface de la sous-couche de liaison avant la formation d'une couche externe céramique, par exemple en zircone yttriée par dépôt physique en phase vapeur.

La demande de brevet EP 0 985 744 décrit encore un autre procédé comprenant la formation d'une couche de platine sur un substrat en superalliage à base nickel par électrodéposition ou par dépôt chimique en phase vapeur et le dépôt d'une couche d'aluminium qui est formée à partir d'un halogénure gazeux et qui diffuse dans la couche de platine. Une désulfurisation est effectuée après chaque dépôt par traitement thermique à une température supérieure à 1050°C et écroûtage superficiel, afin d'éliminer le soufre nuisible à l'adhérence du film d'alumine développé à la surface de la sous-couche de liaison obtenue. A cette température supérieure à 1050°C, une diffusion d'éléments du substrat dans la sous-couche de liaison est inévitable.

Un procédé de formation d'une sous-couche de liaison comprenant du platine et de l'aluminium est aussi décrit dans le brevet US 5 856 027. Une couche de platine est formée sur le substrat en superalliage par électrodéposition, avant dépôt d'aluminium par dépôt chimique en phase vapeur avec introduction éventuelle d'éléments réactifs. La sous-couche obtenue présente une zone de diffusion interne avec présence de nickel diffusé depuis le substrat.

Avec ces procédés connus, le mode de formation de la sous-couche de liaison provoque une interaction avec le substrat. La déposante a constaté que divers éléments du substrat en superalliage, en diffusant au sein de la sous-couche de liaison, peuvent y former des précipités indésirables, notamment susceptibles d'affecter la tenue du film d'alumine développé à la surface de la sous-couche de liaison. En outre, la composition précise de la sous-couche de liaison est difficilement contrôlable.

### Objet et résumé de l'invention

L'invention a pour but de fournir un procédé permettant de former sur un substrat en superalliage un revêtement de protection formant barrière thermique et ayant une sous-couche de liaison en un composé intermétallique chimiquement stable comprenant au moins un métal du groupe du platine et de l'aluminium, la sous-couche de liaison étant de composition contrôlable, pouvant avoir une épaisseur relativement faible, étant réalisée sensiblement sans interaction avec le substrat susceptible de provoquer une diffusion d'éléments du substrat dans la sous-couche de liaison, et ayant la capacité de formation à sa surface d'un mince film adhésif et persistant en alumine permettant l'accrochage d'une couche externe en céramique.

Ce but est atteint par un procédé tel que défini par la revendication 1.

Par groupe du platine, on entend ici le groupe constitué par le platine, le palladium, le rhénium, le ruthénium, l'osmium et l'iridium.

Dans un procédé de dépôt physique en phase vapeur, le substrat est chauffé par le seul contact avec un nuage de vapeur contenant l'élément à déposer. La température du substrat est donc relativement peu élevée, puisqu'elle ne dépasse pas en pratique 700°C. Le substrat reste donc à une température bien inférieure à celle à partir de laquelle des éléments du substrat sont susceptibles de diffuser dans le dépôt formé.

On notera aussi que les procédés de dépôt physique en phase vapeur permettent de contrôler les épaisseurs des couches élémentaires déposées ce qui, allié à l'absence ou quasi-absence d'éléments diffusés du substrat, autorise la formation d'une sous-couche de liaison de composition précisément contrôlée, déterminée par le rapport entre les épaisseurs des couches de platine et d'aluminium déposées.

Selon une particularité du procédé, après dépôt des couches élémentaires, un traitement thermique est réalisé afin de provoquer la formation du composé intermétallique par réaction entre les métaux des couches déposées.

De préférence, le traitement thermique est réalisé à une température au plus égale à 900°C, pour éviter la diffusion d'éléments provenant du substrat.

De préférence encore, le traitement thermique est réalisé sous atmosphère non oxydante, par exemple sous vide ou sous atmosphère neutre.

Selon une autre particularité du procédé, la sous-couche de liaison a une épaisseur totale inférieure à 50 µm, typiquement comprise entre 3 et 30 µm. Cette épaisseur est très sensiblement inférieure à celle de sous-couches de l'art antérieur.

Les couches élémentaires ont, au moins pour l'aluminium, une épaisseur de préférence au plus égale à 1 500 nm, mais qui peut être au plus égale à 200 nm.

Ainsi, le nombre de couches élémentaires peut varier entre quelques-unes, typiquement au moins 3, et plusieurs dizaines, voire plusieurs centaines.

Lorsque, pour une épaisseur totale donnée, le nombre de couches élémentaires est relativement peu élevé, la sous-couche de liaison conserve une apparence feuilletée dans le revêtement obtenu, sans toutefois que l'adhérence de celui-ci soit sensiblement affectée.

Par contre, lorsque, pour une même épaisseur totale, le nombre de couches élémentaires est relativement élevé, la sous-couche de liaison en composé intermétallique obtenue présente une structure homogène.

L'épaisseur de chaque couche élémentaire de platine telle que déposée peut être constante pendant tout le processus de dépôt, ou peut être variable. Il en est de même pour l'épaisseur des couches élémentaires d'aluminium telles que déposées. On pourra en particulier réaliser des séries de dépôt de couches de platine et d'aluminium d'épaisseurs relativement faibles, en intercalant entre ces séries le dépôt d'au moins une couche de platine et une couche d'aluminium d'épaisseur relativement élevée, de sorte que, après traitement thermique, la sous-couche de liaison offre l'aspect d'une succession de phases homogènes séparées les unes des autres.

En outre, et éventuellement en combinaison avec ce qui précède, on pourra avoir un rapport fixe ou variable entre les épaisseurs des couches de platine et des couches d'aluminium telles que déposées pendant tout le processus de dépôt de sorte que le composé intermétallique obtenu finalement peut avoir une composition fixe ou variable dans l'épaisseur de la sous-couche de liaison.

Les couches élémentaires sont formées par dépôt physique en phase vapeur, par exemple par évaporation sous bombardement électronique ou évaporation sous arc avec ou sans assistance d'un plasma, ou encore par pulvérisation cathodique au moyen d'au moins une première cible constituant une source du métal du groupe du platine et une deuxième cible constituant une source d'aluminium.

Selon une particularité supplémentaire du procédé, au moins un élément réactif, choisi par exemple parmi l'yttrium, le zirconium, l'hafnium et les lanthanides est déposé en plus du métal du groupe du platine et de l'aluminium, pour être introduit dans la sous-couche de liaison. L'élément réactif peut être co-déposé avec le métal du groupe du platine et/ou avec l'aluminium, par exemple en utilisant une source alliée.

Selon une autre particularité supplémentaire du procédé, au moins un métal autre que l'aluminium et le platine peut être déposé, pour améliorer encore la stabilité thermique, par exemple un métal choisi parmi Re, Ni, Co. Ce métal supplémentaire peut être déposé en couches séparées, ou être co-déposé avec l'élément réactif éventuel.

L'invention a aussi pour objet une pièce de turbine à gaz telle qu'elle peut être obtenue par le procédé ci-avant, et plus particulièrement une piéce de turbine à gaz telle que définie par la revendication 23.

Selon une particularité remarquable, la sous-couche de liaison est exempte d'éléments diffusés du substrat. On entend par là que la présence d'éléments du substrat n'a pas été décelée par les méthodes d'analyse usuelles disponibles.

### Brève description des dessins

L'invention sera mieux comprise à la lecture de la description faite ci-après, à titre indicatif mais non limitatif. Il sera fait référence aux dessins annexés, sur lesquels :
- la figure 1 est une vue partielle à échelle agrandie d'un substrat métallique en superalliage muni d'un revêtement de protection,
- la figure 2 montre les étapes successives d'un mode de mise en oeuvre du procédé selon l'invention ;
- la figure 3 est une vue très schématique d'une installation de dépôt physique en phase vapeur utilisable lors de la mise en oeuvre d'un procédé selon l'invention ;
- les figures 4 et 5 sont des microphotographies qui montrent la structure d'une sous-couche de liaison d'un revêtement de protection obtenue suivant un exemple de mise en oeuvre d'un procédé selon l'invention, avant et après traitement thermique ; et
- les figures 6 et 7 sont des microphotographies qui montrent la structure de sous-couches de liaison obtenues suivant d'autres exemples de mise en oeuvre d'un procédé selon l'invention.

### Description détaillée de modes de réalisation de l'invention

Dans la description qui suit, on envisage la réalisation d'une pièce comprenant un substrat métallique en superalliage et un revêtement de protection comprenant une sous-couche de liaison en un composé intermétallique formé essentiellement de platine et d'aluminium, et une couche externe céramique fixée sur un film adhésif d'alumine développé à la surface de la sous-couche de liaison.

Toutefois, l'invention n'est pas limitée à la formation de composés intermétalliques formés essentiellement de platine et d'aluminium, et englobe aussi les composés dans lesquels le platine est remplacé par un autre métal du groupe du platine, ou par un alliage de métaux du groupe du platine. Comme indiqué plus haut, par métal du groupe du platine, on entend ici un métal choisi parmi le platine, le palladium, le rhénium, le ruthénium, l'osmium et l'iridium.

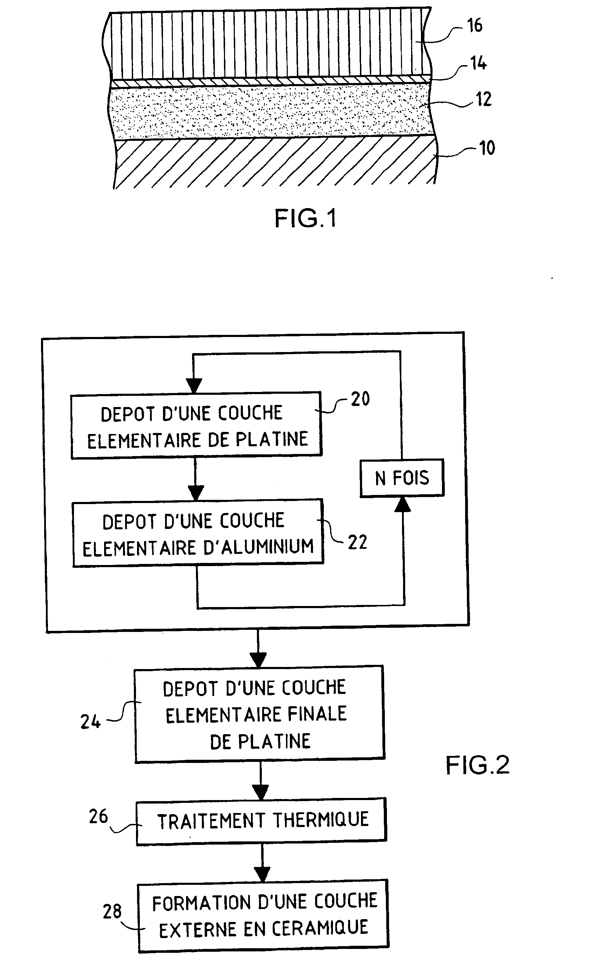

La figure 1 montre très schématiquement en coupe une partie de pièce comprenant un substrat métallique 10 en superalliage muni d'un revêtement de protection.

Le revêtement de protection comprend, à partir de la surface du substrat, une sous-couche de liaison 12, un film d'alumine 14 recouvrant la sous-couche de liaison et une couche externe en céramique 16 accrochée sur le film d'alumine.

La sous-couche de liaison 12 qui, avec le film d'alumine 14, assure la liaison entre le substrat et la couche externe céramique, est formée essentiellement en un composé intermétallique de l'aluminium et du platine, tel que Pt₈Al₂₁, PtAl₂, Pt₂Al₃, PtAl, Pt₅Al₃, ou un mélange de ceux-ci.

D'autres éléments peuvent être ajoutés, notamment des éléments réactifs choisis parmi l'yttrium, le zirconium, l'hafnium et les lanthanides qui renforcent la fonction de barrière de diffusion vis-à-vis d'éléments du substrat susceptibles d'être préjudiciables à la tenue du revêtement protecteur, et qui favorisent la persistance du film d'alumine 14. D'autres métaux peuvent aussi être ajoutés qui ont un effet bénéfique, par exemple du rhénium ou encore du nickel et/ou du cobalt qui améliorent la stabilité thermique du revêtement.

Le film d'alumine 14 est produit par oxydation de l'aluminium de la barrière de diffusion. Il assure une fonction de protection vis-à-vis de la corrosion par oxydation. Il assure aussi, par son caractère "adhésif", l'accrochage du revêtement externe en céramique 16.

Le revêtement externe en céramique 16 assure essentiellement une fonction d'isolant thermique. Il est en oxyde réfractaire, tel que zircone, oxyde d'yttrium ou zircone yttriée. II peut être formé par dépôt physique en phase vapeur, par exemple par évaporation par faisceau électronique ou par évaporation assistée par plasma, comme cela est bien connu en soi.

Le procédé selon l'invention se rapporte principalement à la formation de la sous-couche de liaison 12.

La sous-couche de liaison est formée par une pluralité de couches élémentaires qui sont, alternativement, constituées essentiellement de platine et d'aluminium.

De préférence, la première couche élémentaire déposée sur le substrat est une couche constituée essentiellement de platine, qui est moins susceptible de diffuser dans le substrat métallique que l'aluminium. La dernière couche élémentaire est également de préférence une couche constituée essentiellement de platine car elle n'est pas susceptible de s'oxyder sous air ou sous pression partielle d'oxygène à la fin de l'élaboration de la sous-couche de liaison.

Dans un mode de réalisation du procédé (figure 2), on réalise consécutivement N séquences élémentaires comprenant chacune une phase 20 de dépôt d'une couche élémentaire de platine suivie d'une phase 22 de dépôt d'une couche élémentaire d'aluminium. Immédiatement à la fin des N séquences, une phase 24 de dépôt d'une couche élémentaire finale de platine est réalisée. Le nombre total de couches déposées est donc égal à 2N+1, N étant un nombre entier égal ou supérieur à 1.

Ensuite, une phase 26 de traitement thermique est réalisée de manière à former un composé intermétallique par réaction exothermique entre le platine et l'aluminium des couches élémentaires formées. Le traitement thermique est réalisé à température modérée, au plus égale à 900°C, par exemple de l'ordre de 700°C, de sorte qu'une diffusion d'éléments du substrat métallique dans la partie adjacente du composé intermétallique n'est pas favorisée. Le traitement thermique est réalisé sous atmosphère non oxydante, par exemple sous vide ou atmosphère neutre pendant une durée comprise entre 0,5 et 3 h, par exemple environ 2 h. Lors du traitement thermique, l'aluminium d'une couche diffuse dans les couches adjacentes en platine. Un film fin d'alumine se développe à la surface de la sous-couche de liaison ainsi obtenue lors d'une exposition ultérieure à un milieu oxydant.

Une couche externe en céramique est ensuite formée sur la sous-couche de liaison obtenue (phase 28), avec une croissance du film d'alumine.

Les couches élémentaires sont réalisées avec une épaisseur individuelle, au moins pour l'aluminium, inférieure à 2 000 nm, de préférence au plus égale à 1 500 nm. Cette épaisseur pourra être choisie nettement inférieure à ce seuil, par exemple au plus égale à 200 nm. Une telle épaisseur relativement faible sera choisie si, après traitement thermique, on désire obtenir une structure homogène, c'est-à-dire ne laissant pas subsister de trace de la réalisation de la sous-couche de liaison en couches superposées.

Le nombre N de séquences est déterminé en fonction des épaisseurs des couches élémentaires et de l'épaisseur totale souhaitée pour la sous-couche de liaison. Cette épaisseur totale est avantageusement inférieure à 50 µm, typiquement comprise entre 3 µm et 30 µm, de sorte que le nombre 2N + 1 de couches élémentaires peut varier de plusieurs unités à plusieurs dizaines, voire même plusieurs centaines.

On notera que les couches élémentaires de platine et celles d'aluminium, telles que déposées, peuvent avoir des épaisseurs différentes, le rapport entre l'épaisseur totale des couches de platine et l'épaisseur totale des couches d'aluminium étant fonction de la stoechiométrie du composé intermétallique souhaité. Le rapport entre les épaisseurs des couches de platine et d'aluminium pourra être maintenu constant, ou varier de façon contrôlée au cours du processus de dépôt. Dans ce dernier cas, après traitement thermique, on obtient une sous-couche de liaison avec variation de la composition du composé intermétallique dans l'épaisseur de la sous-couche. On notera en outre que, tant pour les couches élémentaires en platine que pour celles d'aluminium, l'épaisseur peut varier au cours du processus de dépôt, pour un rapport donné entre les épaisseurs des couches de platine et d'aluminium.

Selon un mode de réalisation du procédé, le dépôt des couches élémentaires de platine et d'aluminium est réalisé par pulvérisation cathodique, ce procédé permettant de maîtriser assez précisément la quantité de métal déposé, donc l'épaisseur des couches élémentaires.

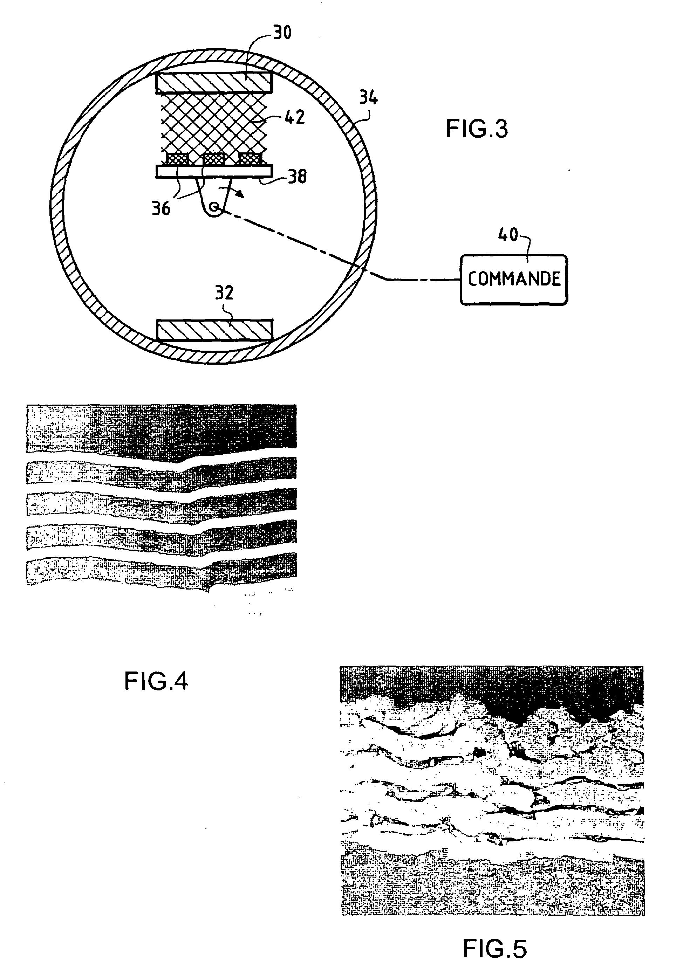

La figure 3 est une vue très schématique d'un mode de réalisation d'une installation de pulvérisation cathodique utilisable pour la mise en oeuvre du procédé.

Des cibles constituant des sources de platine et d'aluminium sous forme d'échantillons massifs 30, 32 sont fixées sur deux côtés opposés de la paroi interne d'une chambre étanche 34. Des pièces 36, ou substrats métalliques en superalliage à revêtir, sont fixés sur un support de pièces rotatif 38 à l'intérieur de la chambre 34.

Le mouvement du support 38 est commandé par une unité de commande programmée 40 agissant sur un moteur (non représenté) entraînant le support 38 de manière à amener les substrats 36 alternativement en regard des cibles 30 et 32.

La chambre 34 ayant été mise sous vide, de l'argon est introduit dans la chambre par une conduite et la pression dans la chambre est réglée à une valeur d'environ 1 Pa (10⁻² mbar).

Par établissement d'une différence de potentiel entre les substrats métalliques et la cible située en regard, le gaz contenu dans la chambre est ionisé, créant un plasma 42. Les ions d'argon sont accélérés vers la cible et en délogent des atomes métalliques sous l'effet de l'énergie d'impact. Les atomes métalliques délogés se déposent sur les substrats.

A titre indicatif, on peut réaliser la pulvérisation cathodique du platine en appliquant à la cible une tension à fréquence radio, sous une puissance de 350 W à 450 W. Afin de favoriser l'accrochage de la première couche élémentaire de platine sur les substrats, ceux-ci peuvent être initialement portés à un potentiel négatif, par exemple -50 V à -150 V. Le potentiel des substrats est ramené à la terre lors des dépôts des couches élémentaires suivantes.

Pour la pulvérisation cathodique de l'aluminium, l'excitation de la cible peut être réalisée par application à la cible d'une tension continue comprise par exemple entre -250 V et -350 V.

La polarisation des substrats 36 et des cibles 30, 32 et les durées des phases de dépôt élémentaires sont commandées par l'unité de commande 40 en fonction d'un programme préétabli pour obtenir une sous-couche de liaison de composition et d'épaisseur totale souhaitées.

Le dépôt d'au moins un métal supplémentaire et/ou d'au moins un élément réactif au sein de la sous-couche de liaison peut être réalisé en utilisant une ou plusieurs cibles supplémentaires.

Afin d'introduire le métal supplémentaire et/ou l'élément réactif de façon homogène dans l'épaisseur de la sous-couche de liaison, des couches élémentaires pourront être alors formées à intervalles réguliers dans l'ensemble des couches de platine et d'aluminium par commande appropriée du positionnement des substrats.

On pourra également associer une source de métal supplémentaire et/ou d'élément réactif à l'une et/ou l'autre des sources de platine et d'aluminium.

On pourra également utiliser une source de platine et/ou une source d'aluminium alliée avec le métal supplémentaire et/ou l'élément réactif à déposer, les proportions des constituants de l'alliage étant choisies en fonction de la quantité relative de métal supplémentaire et/ou d'élément réactif à introduire dans la sous-couche de liaison.

Des procédés de dépôt physique en phase vapeur autres que la pulvérisation cathodique peuvent être utilisés qui permettent également de former des couches élémentaires de très faible épaisseur avec contrôle précis de leur composition. Ces autres procédés sont par exemple le dépôt physique en phase gazeuse par bombardement électronique (EBPVD) ou l'évaporation sous arc, avec ou sans l'assistance d'un plasma.

### Exemple 1

Un substrat métallique d'aube de turbine haute pression de turboréacteur, en superalliage à base de nickel, a été muni d'une sous-couche de liaison en un composé intermétallique de la façon suivante :
5 couches élémentaires de platine d'épaisseur égale à environ 500 nm ont été déposées en alternance avec 4 couches élémentaires d'aluminium d'épaisseur égale à environ 1330 nm. Les couches élémentaires ont été formées par pulvérisation cathodique dans les conditions décrites en référence à la figure 3.

La figure 4 montre les couches élémentaires de platine (couleur claire) et d'aluminium (couleur sombre) telles qu'obtenues après dépôt.

Un traitement thermique sous atmosphère inerte (argon) à 700°C pendant 2 h a ensuite été réalisé. Une sous-couche de liaison d'épaisseur totale égale à environ 7,8 microns et en un composé intermétallique de type PtAl₂ a été obtenue.

La figure 5 montre en coupe la structure de la sous-couche de liaison. On constate que l'aluminium a diffusé au sein des couches de platine et que la nature feuilletée reste apparente.

Un test d'adhérence de type classique a été effectué sur la sous-couche de liaison par fixation à sa surface d'un ruban adhésif et arrachage de celui-ci. En dépit de la structure feuilletée de la sous-couche de liaison, une bonne adhérence au substrat et inter-couches élémentaires est observée.

Une analyse quantitative par spectroscopie à dispersion d'énergie (EDS) révèle l'absence de diffusion dans la sous-couche de liaison d'éléments contenus dans le substrat. La sous-couche de liaison assure donc efficacement la fonction de barrière de diffusion vis-à-vis de ces éléments.

### Exemple 2 (comparatif)

Une sous-couche de liaison ayant sensiblement même épaisseur totale et même composition que celle de l'exemple 1 a été formée sur un même substrat que celui de l'exemple 1 et dans des conditions analogues, sauf qu'elle a été réalisée en déposant 3 couches élémentaires de platine d'épaisseur égale à 833 nm en alternance avec 2 couches élémentaires d'aluminium d'épaisseur égale à 2650 nm. Les tests d'adhérence effectués dans les mêmes conditions que dans l'exemple 1 ont montré une mauvaise adhérence au substrat. En outre la surface extérieure de la sous-couche présente des défauts (dépressions) révélant des fusions localisées de l'aluminium.

### Exemple 3

Un substrat métallique d'aube de turbine haute pression de turboréacteur, en superalliage à base nickel, a été muni d'une sous-couche intermétallique de barrière thermique de la façon suivante :
deux couches élémentaires de platine d'épaisseur égale à environ 1150 nm, ainsi qu'une couche intermédiaire d'aluminium d'une épaisseur environ égale à 1400 nm, ont été déposées sur le substrat. Les couches ont été formées par pulvérisation cathodique.

Un traitement thermique sous atmosphère inerte (argon) à 700°C pendant 2 h a ensuite été réalisé. Les couches de platine et d'aluminium ont alors réagi exothermiquement pour former un composé intermétallique Pt₅Al₃. La sous-couche d'épaisseur totale égale à environ 3,7 microns garde une structure feuilletée.

Une analyse effectuée comme dans l'exemple 1 révèle que la sous-couche n'est composée que des éléments d'apport (aluminium et platine) et ne comporte pas de traces des éléments du substrat.

### Exemple 4 (comparatif)

Sur un substrat en superalliage identique à celui de l'exemple 3, ont été déposées deux couches élémentaires de platine d'épaisseur égale à environ 450 nm et une couche intermédiaire d'aluminium d'une épaisseur environ égale à 2000 nm. Après traitement thermique, la structure toujours feuilletée est friable et l'apparence extérieure révèle des fusions locales de la couche d'aluminium, comme dans l'exemple 2.

Les exemples 2 et 4 montrent qu'au cours du traitement thermique, il se produit une fusion de l'aluminium qui, du fait de la trop grande épaisseur de couche, ne peut diffuser totalement et suffisamment rapidement dans le platine pour y former un composé intermétallique ayant une température de fusion plus élevée. Il est donc souhaitable de limiter l'épaisseur des couches élémentaires, notamment des couches d'aluminium, pour favoriser la formation rapide d'un composé intermétallique. L'épaisseur maximale doit être inférieure à 2000 nm, de préférence inférieure à 1500 nm.

### Exemple 5

Un substrat métallique d'aube de turbine haute pression de turboréacteur, en superalliage à base de nickel, a été muni d'une sous-couche de liaison en un composé intermétallique dans les conditions suivantes.

150 couches élémentaires de platine d'épaisseur égale à environ 16 nm ont été déposées en alternance avec 149 couches élémentaires d'aluminium d'épaisseur égale à environ 35 nm. Les couches élémentaires ont été formées par pulvérisation cathodique dans les conditions décrites en référence à la figure 3.

Un traitement thermique sous atmosphère inerte (argon) pendant 2 h a ensuite été réalisé. Une sous-couche de liaison d'épaisseur totale environ égale à 7,8 microns et en un composé intermétallique de type PtAl₂ a été obtenue.

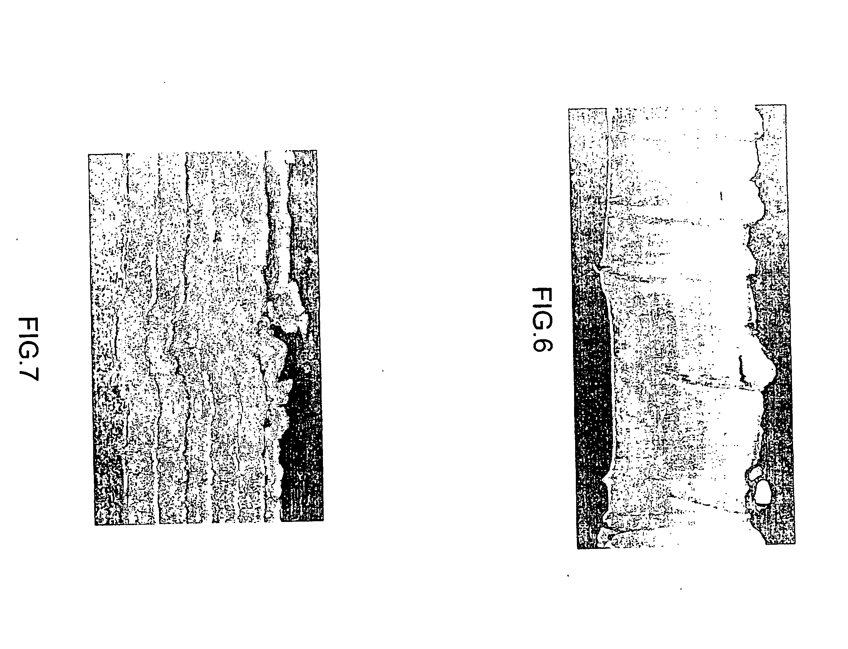

La figure 6 montre en coupe la structure de la sous-couche de liaison obtenue. On constate que la structure est homogène et ne conserve aucun aspect feuilleté.

Des tests d'adhérence, effectués comme dans l'exemple 1, ont donné de très bons résultats.

Comme les exemples 1 et 3, on constate qu'aucun élément du substrat n'a diffusé dans la sous-couche de liaison.

### Exemple 6

Un substrat métallique d'aube de turbine haute pression de turboréacteur, en superalliage à base de nickel, a été muni d'une sous-couche de liaison en un composé intermétallique dans les conditions suivantes :
40 couches élémentaires de platine d'épaisseur égale à environ 70 nm ont été déposées en alternance avec 40 couches élémentaires d'aluminium d'épaisseur environ égale à 130 nm et 40 couches élémentaires de nickel d'épaisseur environ égale à 50 nm.

Après traitement thermique à 900°C pendant 2 h sous atmosphère inerte, une sous-couche d'épaisseur totale environ égale à 10 µm est obtenue par réaction exothermique entre les couches déposées. La sous-couche obtenue est en un composé intermétallique NiPtAl₂ et sa structure est homogène.

### Exemple 7

Une sous-couche de liaison à plusieurs étages de compositions différentes a été formée sur un substrat en superalliage à base de nickel au moyen de l'installation de la figure 3. Chaque étage, ou phase, a été formé par le dépôt d'un total de 50 couches alternativement de platine et d'aluminium de relativement faible épaisseur, et les étages ont été séparés par une paire de couches de platine et d'aluminium de plus grandes épaisseurs.

En outre, on a conféré au rapport entre les épaisseurs des couches de platine et d'aluminium dans les étages, ou phases, une valeur non uniforme, de manière à obtenir une sous-couche étagée, ou multiphases, avec des composés intermétalliques ayant des compositions différentes à différents niveaux de la sous-couche.

De façon plus précise, on a d'abord formé sur le substrat en superalliage une bi-couche formée d'une couche de 200 nm de platine et d'une couche de 300 nm d'aluminium. On a déposé ensuite alternativement 50 couches de platine et d'aluminium. Chaque couche élémentaire de platine avait une épaisseur d'environ 13 nm et chaque couche élémentaire d'aluminium avait une épaisseur d'environ 27 nm afin d'obtenir après traitement thermique un composé intermétallique de PtAl₂. Dans les étages suivants séparés par des bi-couches plus épaisses analogues à celle formée en premier, chaque couche élémentaire de platine avait une épaisseur de 20 nm et chaque couche élémentaire d'aluminium avait une épaisseur d'environ 20 nm afin d'obtenir cette fois le composé intermétallique PtAl. Enfin pour les trois derniers étages, également séparés par des bi-couches plus épaisses analogues aux précédentes, on a choisi de former le composé Pt₈Al₂₁. Pour cela, chaque couche élémentaire de platine avait une épaisseur d'environ 10 nm et chaque couche élémentaire d'aluminium avait une épaisseur d'environ 30 nm.

Un traitement thermique à 700°C pendant 2 h a ensuite été réalisé afin de déclencher une réaction exothermique entre les couches élémentaires.

Comme le montre la coupe de la figure 7, la structure de la sous-couche obtenue après traitement thermique était feuilletée au niveau des couches plus épaisses et homogène au niveau des couches plus fines.

Le dépôt de la sous-couche a été réalisé de façon continue grâce à une programmation contrôlée et automatique de l'installation de la figure 3.

Bien que l'on ait envisagé la réalisation d'une seule bi-couche entre deux étages de la sous-couche, ceux-ci pourront bien entendu être séparés en formant plusieurs bi-couches entre deux étages successifs ou entre le substrat et le premier étage.

La réalisation d'une sous-couche de liaison avec étagement de la composition du composé intermétallique permet d'assigner des fonctions particulières à différents niveaux de la sous-couche. Un élément réactif et/ou un métal supplémentaire peuvent être ajoutés dans un ou plusieurs étages de la sous-couche.

Une sous-couche ayant une macrostructure feuilletée telle que celle de la figure 7, avec plusieurs étages, ou phases superposées, distincts, permet d'interrompre une éventuelle formation colonnaire du composé intermétallique, qui pourrait à terme favoriser une migration d'éléments venant du substrat.

Une telle macrostructure feuilletée pourra aussi être adoptée dans le cas où la composition du composé intermétallique est la même dans chaque étage, c'est-à-dire avec un rapport constant entre les épaisseurs des couches dans les étages (ce qui ne signifie pas nécessairement une épaisseur constante pour les couches de platine et pour les couches d'aluminium).

Bien entendu, une variation de la composition du composé intermétallique peut être réalisée sans procéder au dépôt périodique de bi-couches plus épaisses, la sous-couche pouvant avoir alors un aspect globalement homogène.

## Revendications

1. Procédé de réalisation d'un revêtement de protection formant barrière thermique sur un substrat métallique en superalliage, comprenant la formation, sur le substrat, d'une sous-couche de liaison en un composé intermétallique comprenant au moins de l'aluminium et un métal du groupe du platine, et la formation d'une couche externe en céramique qui s'ancre sur un film d'alumine présent à la surface de la sous-couche de liaison,
**caractérisé en ce que** la sous-couche de liaison est formée par dépôt physique en phase vapeur d'une pluralité de couches élémentaires alternativement en un métal du groupe du platine et en aluminium, les couches élémentaires ayant chacune, au moins pour l'aluminium, une épaisser inférieure à 200 nm, et par réaction exothermique entre les métaux des couches formées.

2. Procédé selon la revendication 1, **caractérisé en ce que**, après dépôt des couches élémentaires, on réalise un traitement thermique afin de provoquer la formation du composé intermétallique par réaction entre les métaux des couches déposées.

3. Procédé selon la revendication 2, **caractérisé en ce que** le traitement thermique est réalisé à une température au plus égale à 900°C.

4. Procédé selon l'une quelconque des revendications 1 à 3, **caractérisé en ce que** l'on forme une sous-couche de liaison ayant une épaisseur totale inférieure à 50 µm.

5. Procédé selon la revendication 4, **caractérisé en ce que** l'on forme une sous-couche de liaison ayant une épaisseur totale comprise entre 3 et 30 µm.

6. Procédé selon l'une quelconque des revendications 1 à 5, **caractérisé en ce que** l'on forme des couches élémentaires ayant chacune, au moins pour l'aluminium, une épaisseur de préférence au plus égale à 1 500 nm.

7. Procédé selon la revendication 6, **caractérisé en ce que** l'on forme des couches élémentaires ayant chacune une épaisseur au plus égale à 200 nm.

8. Procédé selon l'une quelconque des revendications 1 à 7, **caractérisé en ce que** la première et la dernière couche élémentaire déposées sont des couches comprenant le métal du groupe du platine.

9. Procédé selon l'une quelconque des revendications 1 à 8, **caractérisé en ce qu'**au moins un élément réactif est déposé en plus du métal du groupe du platine et de l'aluminium, pour être introduit dans la sous-couche de liaison.

10. Procédé selon la revendication 9, **caractérisé en ce que** l'élément réactif est choisi parmi l'yttrium, le zirconium, l'hafnium et les lanthanides.

11. Procédé selon l'une quelconque des revendications 9 et 10, **caractérisé en ce que** l'élément réactif est codéposé avec le métal du groupe du platine et/ou avec l'aluminium.

12. Procédé selon l'une quelconque des revendications 1 à 11, **caractérisé en ce qu'**au moins un métal autre que le platine et l'aluminium est déposé pour être introduit dans la sous-couche de liaison.

13. Procédé selon l'une quelconque des revendications 1 à 12, **caractérisé en ce que** les couches élémentaires sont formées par pulvérisation cathodique au moyen d'au moins une première cible constituant une source du métal du groupe du platine et une deuxième cible constituant une source d'aluminium.

14. Procédé selon la revendication 13, **caractérisé en ce que** l'on monte un substrat métallique en superalliage sur un support et l'on commande automatiquement un déplacement relatif entre les cibles et le support pour former les couches élémentaires par exposition du substrat alternativement à la première et à la deuxième cible pendant des durées prédéterminées.

15. Procédé selon l'une quelconque des revendications 13 et 14, **caractérisé en ce que** l'on utilise au moins une cible constituant une source d'élément réactif.

16. Procédé selon la revendication 15, **caractérisé en ce que** l'une au moins des première et deuxième cibles comprend l'élément réactif sous forme alliée.

17. Procédé selon l'une quelconque des revendications 13 à 16, **caractérisé en ce que** l'on utilise au moins une cible constituant une source de métal supplémentaire autre que le platine et l'aluminium.

18. Procédé selon l'une quelconque des revendications 1 à 17, **caractérisé en ce que** l'épaisseur des couches élémentaires de platine telles que déposées est variable.

19. Procédé selon l'une quelconque des revendications 1 à 18, **caractérisé en ce que** l'épaisseur des couches élémentaires d'aluminium telles que déposées est variable.

20. Procédé selon l'une quelconque des revendications 1 à 19, **caractérisé en ce que** l'on fait varier le rapport entre les épaisseurs des couches de platine et des couches d'aluminium, telles que déposées, de façon contrôlée.

21. Procédé selon l'une quelconque des revendications 1 à 20, **caractérisé en ce que** l'on réalise la sous-couche de liaison sous forme étagée, la formation de chaque étage comprenant le dépôt d'une pluralité de couches de platine alternant avec des couches d'aluminium.

22. Procédé selon la revendication 21, **caractérisé en ce que** le rapport entre les épaisseurs des couches de platine et des couches d'aluminium prend des valeurs différentes pour différents étages.

23. Pièce de turbine à gaz comprenant un substrat métallique en superalliage, une sous-couche de liaison formée directement sur le substrat et réalisée en un composé intermétallique comprenant un métal du groupe du platine et de l'aluminium, un film adhésif d'alumine formé à la surface de la sous-couche de liaison et un revêtement externe en céramique ancré sur le film d'alumine,
**caractérisée en ce que** la sous-couche de liaison a une épaisseur comprise entre 3 et 30 µm, et est exempte d'éléments diffusés du substrat.

24. Pièce de turbine à gaz selon la revendication 23, **caractérisée en ce que** la sous-couche de liaison comprend en outre au moins un élément réactif choisi parmi le groupe constitué par l'yttrium, le zirconium, l'hafnium et les lanthanides.

25. Pièce de turbine à gaz selon l'une quelconque des revendications 23 et 24, **caractérisée en ce que** la sous-couche de liaison comprend en outre au moins un métal supplémentaire autre que le platine et l'aluminium.

26. Pièce de turbine à gaz selon l'une quelconque des revendications 23 à 25, **caractérisée en ce que** la sous-couche de liaison présente une structure sensiblement homogène.

27. Pièce de turbine à gaz selon l'une quelconque des revendications 23 à 25, **caractérisée en ce que** la sous-couche de liaison présente une structure feuilletée.

28. Pièce de turbine à gaz selon l'une quelconque des revendications 23 à 27, **caractérisée en ce que** la sous-couche de liaison a une composition variable contrôlée dans son épaisseur.

29. Pièce de turbine à gaz selon l'une quelconque des revendications 23 à 28, **caractérisée en ce que** la sous-couche de liaison présente plusieurs étages, ou phases, superposés distincts.

30. Pièce de turbine à gaz selon la revendication 29, **caractérisée en ce que** la sous-couche de liaison présente des étages de compositions différentes.

## Claims

1. A method of making a protective coating forming a thermal barrier on a superalloy metal substrate, the method comprising forming a bonding underlayer of an intermetallic compound on the substrate, the underlayer comprising at least aluminum and a metal from the platinum group, and the method further comprising forming a ceramic outer layer which is anchored on an alumina film present on the surface of the bonding underlayer,
the method being **characterized in that** the bonding underlayer is formed by using physical vapor deposition to deposit a plurality of individual layers alternately of aluminum and of a metal from the platinum group, the individual layers each having, at least for aluminum, a thickness of less than 2000 nm, and by causing the metals of the resulting layers to react together exothermally.

2. A method according to claim 1, **characterized in that** once the individual layers have been deposited, heat treatment is performed in order to cause the intermetallic compound to be formed by causing the metals of the deposited layers to react together.

3. A method according to claim 2, **characterized in that** the heat treatment is performed at a temperature of not more than 900°C.

4. A method according to any one of claims 1 to 3, **characterized in that** a bonding underlayer is formed having total thickness of less than 50 µm.

5. A method according to claim 4, **characterized in that** a bonding underlayer is formed having a total thickness lying in the range 3 µm to 30 µm.

6. A method according to any one of claims 1 to 5, **characterized in that** individual layers are formed in which at least each aluminum layer is of a thickness preferably of not more than 1500 nm.

7. A method according to claim 6, **characterized in that** each individual layer is formed with a thickness not greater than 200 nm.

8. A method according to any one of claims 1 to 7, **characterized in that** the first and the last individual layers to be deposited are layers comprising the metal from the platinum group.

9. A method according to any one of claims 1 to 8, **characterized in that** at least one reactive element is deposited in addition to the aluminum and the metal from the platinum group, in order to include said reactive element in the bonding underlayer.

10. A method according to claim 9, **characterized in that** the reactive element is selected from yttrium, zirconium, hafnium, and the lanthanides.

11. A method according to claim 9 or claim 10, **characterized in that** the reactive element is codeposited with the aluminum and/or with the metal from the platinum group.

12. A method according to any one of claims 1 to 11, **characterized in that** at least one metal other than the aluminum and the platinum is deposited in order to be included in the bonding underlayer.

13. A method according to any one of claims 1 to 12, **characterized in that** the individual layers are formed by cathode sputtering by means of at least a first target constituting a source of the metal from the platinum group and a second target constituting a source of aluminum.

14. A method according to claim 13, **characterized in that** a superalloy metal substrate is mounted on a support and the targets and the support are caused to perform relative displacement automatically in order to form the individual layers by exposing the substrate alternately to the first target and to the second target for predetermined durations.

15. A method according to claim 13 or claim 14, **characterized in that** at least one target is used constituting a source of reactive element.

16. A method according to claim 15, **characterized in that** at least one of the first and second targets includes the reactive element in alloyed form.

17. A method according to any one of claims 13 to 16, **characterized in that** at least one target is used constituting a source of an additional metal other than Pt or Al.

18. A method according to any one of claims 1 to 17, **characterized in that** the individual layers of platinum are deposited with varying thicknesses.

19. A method according to any one of claims 1 to 18, **characterized in that** the individual layers of aluminum are deposited with varying thicknesses.

20. A method according to any one of claims 1 to 19, **characterized in that** the ratios between the thicknesses of the deposited layers of platinum and of aluminum are caused to vary in controlled manner.

21. A method according to any one of claims 1 to 20, **characterized in that** the bonding underlayer is made in staged form, with the formation of each stage or phase comprising depositing a plurality of layers of platinum in alternation with layers of aluminum.

22. A method according to claim 21, **characterized in that** the ratio between the thicknesses of the layers of platinum and the layers of aluminum takes on different values for different phases.

23. A gas turbine part comprising a superalloy metal substrate, a bonding underlayer formed directly on the substrate and made of an intermetallic compound comprising aluminum and a metal from the platinum group, an adhesive film of alumina formed on the surface of the bonding underlayer, and an outer coating of ceramic anchored on the alumina film,
the part being **characterized in that** the bonding underlayer has a thickness lying in the range 3 µm to 30 µm and is free from elements diffused from the substrate.

24. A gas turbine part according to claim 23, **characterized in that** the bonding underlayer further comprises at least one reactive element selected from the group constituted by yttrium, zirconium, hafnium, and the lanthanides.

25. A gas turbine part according to any one of claims 23 and 24, **characterized in that** the bonding underlayer further comprises at least one additional metal other than the platinum and the aluminum.

26. A gas turbine part according to any one of claims 23 to 25, **characterized in that** the bonding underlayer presents a structure that is substantially homogeneous.

27. A gas turbine part according to any one of claims 23 to 25, **characterized in that** the bonding underlayer presents a structure that is laminated.

28. A gas turbine part according to any one of claims 23 to 25, **characterized in that** the bonding underlayer is of composition that varies in controlled manner within its thickness.

29. A gas turbine part according to any one of claims 23 to 28, **characterized in that** the bonding underlayer presents a plurality of distinct superposed stages or phases.

30. A gas turbine part according to claim 29, **characterized in that** the bonding underlayer presents phases of different compositions.

## Patentansprüche

1. Verfahren zur Herstellung einer Wärmedämmschicht auf einem metallischen Substrat aus Superlegierung, umfassend die Bildung einer Verbindungsunterschicht aus einer intermetallischen Verbindung, umfassend mindestens Aluminium und ein Metall der Platingruppe, auf dem Substrat und die Bildung einer Außenschicht aus Keramik, die sich auf einem auf der Oberfläche der Verbindungsunterschicht vorhandenen Aluminiumoxidfilm verankert,
**dadurch gekennzeichnet, daß** die Verbindungsunterschicht von einer physikalischen Ablagerung einer Vielzahl von elementaren Schichten in Dampfphase alternativ aus einem Metall der Platingruppe und aus Aluminium, wobei die elementaren Schichten jeweils zumindest für das Aluminium eine Dicke unter 2000 nm aufweisen, und von einer exothermen Reaktion zwischen den Metallen der erzeugten Schichten gebildet ist.

2. Verfahren nach Anspruch 1, **dadurch gekennzeichnet, daß** nach Ablagerung der elementaren Schichten eine Wärmebehandlung durchgeführt wird, um die Bildung einer intermetallischen Verbindung durch Reaktion zwischen den Metallen der abgelagerten Schichten hervorzurufen.

3. Verfahren nach Anspruch 2, **dadurch gekennzeichnet, daß** die Wärmebehandlung bei einer Temperatur höchstens gleich 900° C durchgeführt wird.

4. Verfahren nach einem der Ansprüche 1 bis 3, **dadurch gekennzeichnet, daß** eine Verbindungsunterschicht mit einer Gesamtdicke unter 50 µm gebildet wird.

5. Verfahren nach Anspruch 4, **dadurch gekennzeichnet, daß** eine Verbindungsunterschicht mit einer Gesamtdicke zwischen 3 und 30 µm gebildet wird.

6. Verfahren nach einem der Ansprüche 1 bis 5, **dadurch gekennzeichnet, daß** elementare Schichten gebildet werden, die jeweils zumindest für das Aluminium eine Dicke von vorzugsweise höchstens gleich 1500 nm aufweisen.

7. Verfahren nach Anspruch 6, **dadurch gekennzeichnet, daß** elementare Schichten gebildet werden, die jeweils eine Dicke höchstens gleich 200 nm aufweisen.

8. Verfahren nach einem der Ansprüche 1 bis 7, **dadurch gekennzeichnet, daß** die erste und die zweite abgelagerte elementare Schicht Schichten sind, die das Metall der Platingruppe umfassen.

9. Verfahren nach einem der Ansprüche 1 bis 8, **dadurch gekennzeichnet, daß** mindestens ein Reagens zusätzlich zum Metall der Platingruppe und dem Aluminium aufgebracht wird, um in die Verbindungsunterschicht eingeleitet zu werden.

10. Verfahren nach Anspruch 9, **dadurch gekennzeichnet, daß** das Reagens unter Yttrium, Zirkonium, Hafnium und den Lanthaniden ausgewählt wird.

11. Verfahren nach einem der Ansprüche 9 und 10, **dadurch gekennzeichnet, daß** das Reagens gemeinsam mit dem Metall der Platingruppe und/oder mit dem Aluminium aufgebracht wird.

12. Verfahren nach einem der Ansprüche 1 bis 11, **dadurch gekennzeichnet, daß** mindestens ein weiteres Metall als Platin und Aluminium aufgebracht wird, um in die Verbindungsunterschicht eingeleitet zu werden.

13. Verfahren nach einem der Ansprüche 1 bis 12, **dadurch gekennzeichnet, daß** die elementaren Schichten durch Kathodenzerstäubung mit Hilfe mindestens eines ersten Ziels, das eine Quelle des Metalls der Platingruppe darstellt, und eines zweiten Ziels das eine Aluminiumquelle darstellt, gebildet werden.

14. Verfahren nach Anspruch 13, **dadurch gekennzeichnet, daß** ein metallisches Substrat aus Superlegierung auf einem Träger montiert und automatisch eine relative Verschiebung zwischen den Zielen und dem Träger gesteuert wird, um die elementaren Schichten zu bilden, wobei das Substrat alternativ dem ersten und dem zweiten Ziel während bestimmter Zeitdauern ausgesetzt wird.

15. Verfahren nach einem der Ansprüche 13 und 14, **dadurch gekennzeichnet, daß** mindestens ein Ziel verwendet wird, das eine Quelle eines Reagens darstellt.

16. Verfahren nach Anspruch 15, **dadurch gekennzeichnet, daß** mindestens eines der ersten und zweiten Ziele das Reagens in Form einer Legierung umfaßt.

17. Verfahren nach einem der Ansprüche 13 bis 16, **dadurch gekennzeichnet, daß** mindestens ein Ziel verwendet wird, das eine Quelle anderen eines zusätzlichen Metalls als Platin oder Aluminium darstellt.

18. Verfahren nach einem der Ansprüche 1 bis 17, **dadurch gekennzeichnet, daß** die Dicke der elementaren Platinschichten, wie aufgebracht, variabel ist.

19. Verfahren nach einem der Ansprüche 1 bis 18, **dadurch gekennzeichnet, daß** die Dicke der elementaren Aluminiumschichten, wie aufgebracht, variabel ist.

20. Verfahren nach einem der Ansprüche 1 bis 19, **dadurch gekennzeichnet, daß** das Verhältnis zwischen den Dicken der Platinschichten und der Aluminiumschichten, wie aufgebracht, kontrolliert variiert wird.

21. Verfahren nach einem der Ansprüche 1 bis 20, **dadurch gekennzeichnet, daß** die Verbindungsunterschicht in abgestufter Form hergestellt wird, wobei die Bildung jeder Stufe die Aufbringung einer Vielzahl von Platinschichten, die mit Aluminiumschichten alternieren, umfaßt.

22. Verfahren nach Anspruch 21, **dadurch gekennzeichnet, daß** das Verhältnis zwischen den Dicken der Platinschichten und der Aluminiumschichten unterschiedliche Werte für unterschiedliche Stufen annimmt.

23. Gasturbinenteil, umfassend ein metallisches Substrat aus Superlegierung, eine Verbindungsunterschicht, die direkt auf dem Substrat ausgebildet und aus einer intermetallischen Verbindung, umfassend ein Metall der Platingruppe und Aluminium, hergestellt ist, einen Haftfilm aus Aluminiumoxid, der an der Oberfläche der Verbindungsunterschicht ausgebildet ist, und eine Außenverkleidung aus Keramik, die auf dem Aluminiumoxidfilm verankert ist,
**dadurch gekennzeichnet, daß** die Verbindungsunterschicht eine Dicke zwischen 3 und 30 µm aufweist und frei von Diffusionselementen des Substrats ist.

24. Gasturbinenteil nach Anspruch 23, **dadurch gekennzeichnet, daß** die Verbindungsunterschicht ferner mindestens ein Reagens umfaßt, das in der Gruppe, die von Yttrium, Zirkonium, Hafnium und den Lanthaniden gebildet ist, ausgewählt wird.

25. Gasturbinenteil nach einem der Ansprüche 23 und 24, **dadurch gekennzeichnet, daß** die Verbindungsunterschicht ferner mindestens ein anderen zusätzliches Metalls als Platin und Aluminium umfaßt.

26. Gasturbinenteil nach einem der Ansprüche 23 bis 25, **dadurch gekennzeichnet, daß** die Verbindungsunterschicht eine im wesentlichen homogene Struktur aufweist.

27. Gasturbinenteil nach einem der Ansprüche 23 bis 25, **dadurch gekennzeichnet, daß** die Verbindungsunterschicht eine schichtige Struktur aufweist.

28. Gasturbinenteil nach einem der Ansprüche 23 bis 27, **dadurch gekennzeichnet, daß** die Verbindungsunterschicht eine in ihrer Dicke kontrollierte variable Zusammensetzung aufweist.

29. Gasturbinenteil nach einem der Ansprüche 23 bis 28, **dadurch gekennzeichnet, daß** die Verbindungsunterschicht mehrere getrennte übereinander angeordnete Stufen oder Phasen aufweist.

30. Gasturbinenteil nach Anspruch 29, **dadurch gekennzeichnet, daß** die Verbindungsunterschicht Stufen unterschiedlicher Zusammensetzungen aufweist.
